(19) Europäisches Patentamt

European Patent Office

Office européen des brevets

(11) **EP 1 217 412 B1**

(12) **EUROPÄISCHE PATENTSCHRIFT**

(45) Veröffentlichungstag und Bekanntmachung des Hinweises auf die Patenterteilung:
**08.03.2006 Patentblatt 2006/10**

(51) Int Cl.:
*G02B 13/14* (2006.01)        *G02B 13/24* (2006.01)
*G03F 7/20* (2006.01)

(21) Anmeldenummer: **01128878.4**

(22) Anmeldetag: **05.12.2001**

(54) **Lithographieobjektiv mit einer ersten Linsengruppe, bestehend ausschliesslich aus Linsen positiver Brechkraft und Verfahren zur Herstellung mikrostrukturierter Bauteile mit einem solchen Objektiv**

Lithography objective with a first lens group comprising lenses of positive power only and method for producing microstructured components with such an objective

Objectif pour lithographie avec un premier groupe de lentilles composé exclusivement de lentilles à puissance positive et procede pour la preparation de composants microstructurés utilisant un tel objectif

(84) Benannte Vertragsstaaten:
**AT BE CH CY DE DK ES FI FR GB GR IE IT LI LU MC NL PT SE TR**

(30) Priorität: **22.12.2000 DE 10064685**

(43) Veröffentlichungstag der Anmeldung:
**26.06.2002 Patentblatt 2002/26**

(73) Patentinhaber: **Carl Zeiss SMT AG 73446 Oberkochen (DE)**

(72) Erfinder:
• **Schuster, Karl-Heinz 89551 Königsbronn (DE)**

• **Epple, Alexander, Dr. 73431 Aalen (DE)**

(74) Vertreter: **Müller-Rissmann, Werner Albrecht et al Carl Zeiss, Patentabteilung 73446 Oberkochen (DE)**

(56) Entgegenhaltungen:
**EP-A- 0 332 201        US-A- 5 969 803
US-A- 5 990 926**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Projektionsobjektiv für die Mikrolithographie, das mindestens zwei Linsengruppen, die positive Brechkraft aufweisen, umfaßt.

Aus der US 5,990,926 ist ein Projektionsobjektiv für die Mikrolithographie bekannt, das drei Bäuche, also drei Linsengruppen positiver Brechkraft aufweist. Das Objektiv wird in Ausbreitungsrichtung des Lichtes betrachtet. Dabei weist die erste Linsengruppe nur positive Linsen auf, wobei die waferseitige numerische Apertur 0,6 beträgt.

Aus der US 5,969,803 sind Projektionsobjektive für die Mikrolithographie bekannt, die drei Bäuche, also drei positive Linsengruppen umfassen. Die numerische Apertur beträgt wiederum 0,6, wobei es sich um ein rein sphärisches Objektiv handelt.

Aus der EP 332 201 ist ein Objektiv für die Mikrolithographie bekannt, bei dem zur Verbesserung der Abbildungsqualität waferseitig die letzten beiden Linsen jeweils eine asphärische Linsenoberfläche aufweisen und wobei die asphärischen Linsenoberflächen zueinander gewandt angeordnet sind.

Die aus dieser Schrift bekannten Projektionssysteme sind für die Photolithographie vorgesehen und weisen dementsprechend eine geringe Anzahl an Linsen auf. Die damit erreichbare Abbildungsqualität entspricht nicht den Anforderungen, die an Projektionssysteme für die Mikrolithographie gestellt werden. Insbesondere ist die numerische Apertur, die mittels dieses Objektives bereitgestellt werden kann, nur 0,45.

Der Erfindung liegt die Aufgabe zugrunde ein Projektionsobjektiv für die Mikrolithographie bereitzustellen, das eine hohe numerische Apertur sowie sehr gute Abbildungsqualitäten aufweist.

Die Aufgabe der Erfindung wird durch die Merkmale der Patentansprüche 1 und 11 gelöst.

Durch die Maßnahme, eine erste Linsengruppe derart auszugestalten, daß diese Linsengruppe nur aus Linsen positiver Brechkraft besteht und die Anzahl von Linsen positiver Brechkraft der ersten Linsengruppe kleiner ist, als die Anzahl der positiven Linsen, die vor der Blende der weiteren Linsengruppe positiver Brechkraft angeordnet sind, wird ein Projektionsobjektiv bereitgestellt, das eine besonders hohe numerische Apertur bei geringer Baulänge aufweist.

Durch das Vorsehen der ersten Linsengruppe, die nur aus Linsen positiver Brechkraft besteht, wird im Eingangsbereich des Objektives eine Aufweitung des Eingangsstrahls vermieden. Aufgrund dieser Maßnahme kann diese erste Linsengruppe sehr schlank, d.h. die Linsen haben einen kleinen Durchmesser, ausgestaltet werden. Dadurch wird zum einen weniger Material in der ersten Linsengruppe benötigt, zum anderen wird der von dieser Linsengruppe beanspruchte Bauraum reduziert, der für eine Erhöhung der numerischen Apertur durch Vorsehen weiterer positiver Linsen vor der Blende verwendet werden kann.

Bei einer besonders schlank ausgestalteten ersten Linsengruppe ist es aufgrund des Bauraumgewinnes durch eine geringfügige Vergrößerung der nachfolgenden Linsengruppen positiver Brechkraft möglich vermehrt die Petzval-Korrektur in diese nachfolgenden Linsengruppen positiver Brechkraft hinein zu verlagern. Einen besonders großen Beitrag zur Petzval-Korrektur liefert die positive Linsengruppe, in der die Blende angeordnet ist, in Verbindung mit der starken Strahl-Einengung vor dieser Gruppe durch eine starke negative Brechkraft.

Vorzugsweise ist der Durchmesser der Linsen der ersten Linsengruppe kleiner als das 1,3-fache des Objektfeldes.

Es hat sich als vorteilhaft herausgestellt, in der ersten Linsengruppe mindestens eine Linse mit einer asphärischen Oberfläche zu versehen, die zur Verbesserung der Abbildungsqualität des Objektives beiträgt.

Es hat sich als vorteilhaft herausgestellt, asphärische Linsenoberflächen in der ersten Linsengruppe vorzusehen, die um mehr als 300 $\mu$m gegenüber der am besten passenden sphärischen Linsenoberfläche abweichen. Insbesondere hat sich die Anordnung einer derartigen Asphäre auf der objektseitigen Linsenoberfläche der ersten Linse der Linsenanodnung als vorteilhaft herausgestellt. Diese starken Asphärizitäten dicht hinter dem Reticle sind notwendig und besonders effektiv, um die feldabhängigen Aberration zu korrigieren. Die Größe der Asphärizität hängt von den Büschelquerschnitten und der Eingangsapertur, die stets geringer ist als die Ausgangsapertur, ab. Obwohl die Abweichung zur Sphäre groß ist, erzeugt eine einfache Asphärenform den günstigsten Beitrag zur Gesamtbildfehlerkorrektur. In Folge der einfachen Asphärenform bleibt diese Asphärenform dennoch sehr gut fertigbar.

Weitere vorteilhafte Maßnahmen sind in weiteren Unteransprüchen beschrieben.

Anhand einiger Ausführungsbeispiele wird die Erfindung näher erläutert.

Es zeigt:

Figur 1:     Schematischer Aufbau eines Projektionsbelichtungsanlage;

Figur 2:     Projektionsobjektiv für 248 nm mit einer numerischen Apertur von 0,8;

Figur 3:     Projektionsobjektiv für 193 nm mit einer numerischen Apertur von 0,8; und

Figur 4:     Projektionsobjektiv für 248 nm mit einer numerischen Apertur von 0,8.

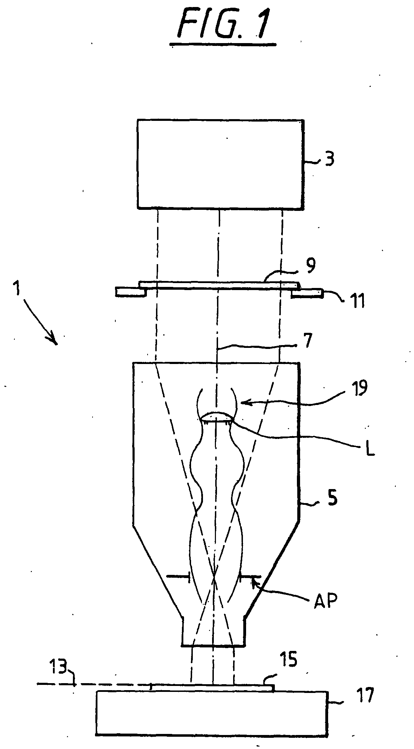

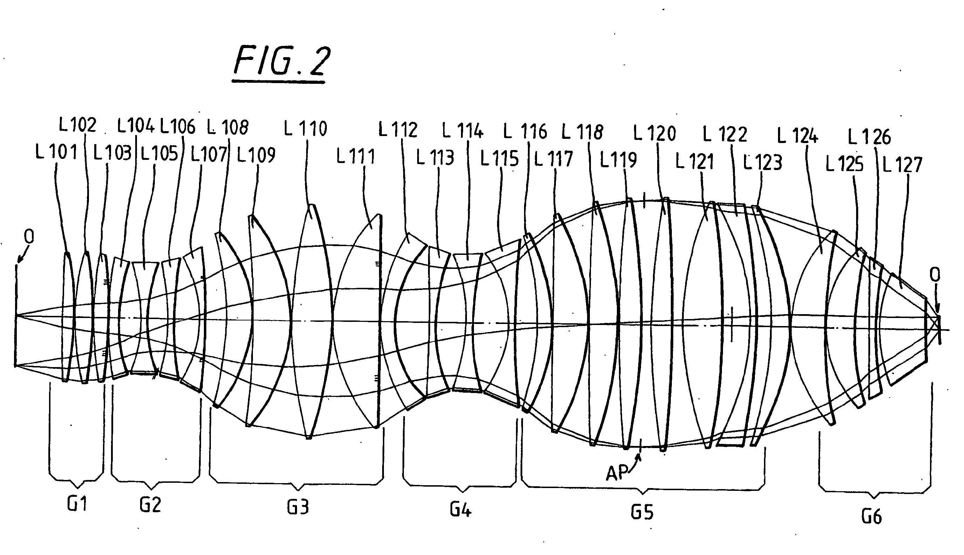

Anhand von Figur 1 wird zunächst der prinzipielle Aufbau einer Projektionsbelichtungsanlage beschrieben. Die Projektionsbelichtungsanlage 1, weist eine Belichtungseinrichtung 3 und Projektionsobjektiv 5 auf. Das Projektionsobjektiv 5 umfaßt eine Linsenanordnung 19 mit einer Aperturblende AP, wobei durch die Linsenanordnung 19 eine optische Achse 7 definiert wird. Verschiedene Linsenanordnungen werden nachfolgend anhand der Figuren 2 bis 3 näher erläutert. Zwischen Beleuchtungseinrichtung 3 und Projektionsobjektiv 5 ist eine Maske 9 angeordnet, die mittels eines Maskenhalters 11 im Strahlengang gehalten wird. Solche in der Mikrolithographie verwendete Masken 9 weisen eine Mikrometer-Nanometer Struktur auf, die mittels des Projektionsobjektives 5 bis zu einem Faktor von 10, insbesondere von um den Faktor 4, verkleinert auf eine Bildebene 13 abgebildet wird. In der Bildebene 13 wird ein durch einen Substrathalter 17 positionierte Substrat 15, bzw. ein Wafer, gehalten.

Die noch auflösbaren minimalen Strukturen hängen von der Wellenlänge λ des für die Beleuchtung verwendeten Lichtes sowie von der bildseitigen numerischen Apertur des Projektionsobjektives 5 ab, wobei die maximal erreichbare Auflösung der Projektionsbelichtungsanlage 1 mit abnehmender Wellenlänge λ der Beleuchtungseinrichtung 3 und mit zunehmender bildseitiger numerischer Apertur des Projektionsobjektives 5 steigt.

In Figur 2 ist ein Projektionsobjektiv für die Mikrolithographie gezeigt. Dieses Objektiv umfaßt sechs Linsengruppe.

Die erste Linsengruppe weist drei Positivlinsen L101 - L103 auf, die alle bikonvex sind. Die letzte Linse L103 ist auf der bildseitigen Oberfläche mit einer Asphäre versehen. Durch die vor der ersten Taille vorgesehene asphärische Oberfläche ist insbesondere eine gezielte Korrektur der Koma im Bereich der Bildfeldzone möglich. Diese asphärische Linsenoberfläche hat auf die schiefe sphärische Aberration im Tangentialschnitt und im Sagittalschnitt nur einen geringen Einfluß. Dahingegen kann durch die asphärische Linsenoberfläche nach der Taille die schiefe sagittale Aberration, insbesondere im Bereich zwischen Bildfeldzone und Bildfeldrand, korrigiert werden.

So ist das Vorsehen einer zweiten asphärischen Linsenoberfläche eine wertvolle Maßnahme, um bei erhöhter Apertur einer durch Koma begründeten Verringerung der Bildqualität entgegenzuwirken.

Die zweite Linsengruppe umfaßt vier Linsen L104 - L107. Die bildseitig angeordnete Linsenoberfläche dieser letzten Linse L107 der zweiten Linsengruppe weist eine asphärische Linsenoberfläche auf. Mittels dieser asphärischen Linsenoberfläche ist insbesondere eine Korrektur von Bildfehlern im Bereich zwischen Bildfeldzone und Bildfeldrand möglich. Insbesondere können die Bildfehler höherer Ordnung, die bei Betrachtung von Sagittalschnitten deutlich werden, korrigiert werden. Da sich diese im Sagittalschnitt ersichtlichen Bildfehler besonders schwer korrigieren lassen, ist dies ein besonders wertvoller Beitrag.

Die dritte Linsengruppe umfaßt die Linsen L108 - L111. Diese Linsengruppe weist positive Brechkraft auf. Wiederum ist die letzte, bildseitig angeordnete Linsenoberfläche der letzten Linse dieser Linsengruppe asphärisiert. Diese Asphäre wirkt sich einerseits vorteilhaft auf die Koma aus, andererseits wirkt diese Asphäre korrigierend auf die axiale und die schiefe sphärische Aberration. Die Korrektur der Aberration ist aufgrund der großen Büscheldurchmesser im Bereich dieser asphärischen Oberfläche besonders gut möglich.

Die darauffolgende Linsengruppe mit den Linsen L112 - L115 weist negative Brechkraft auf.

In der darauffolgenden Linsengruppe, die positive Brechkraft aufweist und die Linsen L116 - L123 umfaßt, ist eine Blende angeordnet. Diese Blende ist nach der Linse L119 vorgesehen, so daß vor der Blende vier Linsen positiver Brechkraft angeordnet sind. Die gute Korrektur der Bildfehler dieses Objektives geht maßgeblich auch auf die Positivlinsen vor der Blende zurück. Durch den großen Durchmesser dieser Linsen haben diese Linsen eine große Teilbrennweite, wodurch die Feldbelastung sinkt und eine bessere Korrektur bei einer höheren numerischen Apertur möglich ist. Unter anderem wirken sich diese positiven Linsen vor der Blende vorteilhaft auf die Koma aus. Außerdem zeichnet sich diese Linsengruppe durch eine geringe Linsenanzahl aus.

Die sechste und letzte Linsengruppe umfaßt die Linsen L124 - L127. Die genauen Daten der Linsen sind Tabelle 1 zu entnehmen. Das Bildfeld beträgt 8 x 26 mm. Bemerkenswert ist daß dieses Objektiv bei einer derart hohen numerischen Apertur nur 27 Linsen aufweist. Der erforderliche Bauraum für dieses Objektiv beträgt 1000 mm. Die genauen Linsendaten sind der Tabelle 1 zu entnehmen.

**Tabelle 1**

| Linsen | Radius | | Dicke | Material | ½ Linsendurchmesser | Brechzahl bei 248nm |
|---|---|---|---|---|---|---|
| | | | | | | |
| 0 | Unendlich | | 20,9706 | L710 | 61,246 | 0,999982 |
| L101 | 1160,20105 | | 13,5756 | SIO2 | 66,130 | 1,508373 |
| | -363,46168 | | 0,7500 | L710 | 66,788 | 0,999982 |
| L102 | 256,92295 | | 20,1184 | SIO2 | 68,174 | 1,508373 |

Tabelle fortgesetzt

| Linsen | Radius | | Dicke | Material | ½ Linsendurchmesser | Brechzahl bei 248nm |
|---|---|---|---|---|---|---|
| | -429,93637 | | 0,7500 | L710 | 67,973 | 0,999982 |
| L103 | 353,94471 | | 15,3795 | SIO2 | 66,245 | 1,508373 |
| | -1064,34630 | A | 0,7500 | L710 | 65,385 | 0,999982 |
| L104 | 365,62225 | | 10,0788 | SIO2 | 62,164 | 1,508373 |
| | 150,28204 | | 24,6344 | L710 | 57,665 | 0,999982 |
| L105 | -160,21163 | | 7,0000 | SIO2 | 57,121 | 1,508373 |
| | 138,69010 | | 21,4314 | L710 | 57,066 | 0,999982 |
| L106 | -257,68200 | | 7,0000 | SIO2 | 57,709 | 1,508373 |
| | 280,52202 | | 27,7747 | L710 | 62,688 | 0,999982 |
| L107 | -122,86419 | | 7,0000 | SIO2 | 64,152 | 1,508373 |
| | -524,02005 | A | 21,2270 | L710 | 75,975 | 0,999982 |
| L108 | -334,99360 | | 27,7619 | SIO2 | 88,903 | 1,508373 |
| | -142,00372 | | 0,7500 | L710 | 92,514 | 0,999982 |
| L109 | -1079,51219 | | 40,8554 | SIO2 | 109,187 | 1,508373 |
| | -172,00795 | | 0,7500 | L710 | 111,327 | 0,999982 |
| L110 | 438,67858 | | 43,4000 | SIO2 | 122,583 | 1,508373 |
| | -378,94602 | | 0,7500 | L710 | 122,708 | 0,999982 |
| L111 | 162,42382 | | 51,1885 | SIO2 | 113,015 | 1,508373 |
| | -5736,26278 | A | 0,7500 | L710 | 110,873 | 0,999982 |
| L112 | 165,15494 | | 14,7530 | SIO2 | 92,577 | 1,508373 |
| | 110,95539 | | 37,6018 | L710 | 79,631 | 0,999982 |
| L113 | -2352,60464 | | 7,0000 | SIO2 | 78,360 | 1,508373 |
| | 158,84317 | | 34,9167 | L710 | 71,086 | 0,999982 |
| L114 | -168,34448 | | 7,0000 | SIO2 | 70,590 | 1,508373 |
| | 245,44885 | | 39,3735 | L710 | 71,824 | 0,999982 |
| L115 | -113,75821 | | 7,0000 | SIO2 | 72,408 | 1,508373 |
| | 666,85880 | | 23,5469 | L710 | 88,173 | 0,999982 |
| L116 | -278,47485 | | 16,7462 | SIO2 | 90,415 | 1,508373 |
| | -195,62311 | | 0,7500 | L710 | 95.097 | 0,999982 |
| L117 | 1596621,30490 | | 37,6629 | SIO2 | 113,071 | 1,508373 |
| | -223,02293 | | 0,7500 | L710 | 115,353 | 0,999982 |
| L118 | 2651,21287 | | 31,3744 | SIO2 | 127,060 | 1,508373 |
| | -371,06734 | | 0,7500 | L710 | 128,117 | 0,999982 |
| L1.19 | 1313,12466 | | 25,1961 | SIO2 | 131.302 | 1,508373 |
| | -666,16100 | | 0,0 | | 131,498 | 1,000000 |
| | unendlich | | 9,5632 | L710 | 130,856 | 0,999982 |
| Blende | | | 0,0 | | 130,856 | |
| L120 | 812,62806 | | 22,4028 | SIO2 | 132,498 | 1,508373 |

Tabelle fortgesetzt

| Linsen | Radius | | Dicke | Material | ½ Linsendurchmesser | Brechzahl bei 248nm |
|---|---|---|---|---|---|---|
| | -1458,91764 | | 10,9629 | L710 | 132,481 | 0,999982 |
| L121 | 344,45037 | | 42,1137 | SIO2 | 130,307 | 1,508373 |
| | -765,47811 | | 29,1268 | L710 | 129,380 | 0,999982 |
| L122 | -250,24553 | | 7,0000 | SIO2 | 127,451 | 1,508373 |
| | -632,30447 | | 15,5964 | L710 | 127,304 | 0,999982 |
| L123 | -398,61314 | | 20,5840 | SIO2 | 126,393 | 1,508373 |
| | -242,62300 | | 1,2010 | L710 | 126,606 | 0,999982 |
| L124 | 143,95358 | | 37,1050 | SIO2 | 103,455 | 1,508373 |
| | 419,96225 | | 0,8946 | L710 | 100,698 | 0,999982 |
| L125 | 120,37736 | | 30,9217 | SIO2 | 85,039 | 1,508373 |
| | 263,87928 | | 14,8885 | L710 | 79,055 | 0,999982 |
| L126 | 1886,79345 | | 7,6305 | SIO2 | 74,319 | 1,508373 |
| | 277,58693 | | 3,7474 | L710 | 65,935 | 0,999982 |
| L127 | 144,27214 | | 50,1938 | SIO2 | 58,929 | 1,508373 |
| | 423,41846 | | 15,0000 | L710 | 32,250 | 0,999982 |
| 0' | unendlich | | 0,0001 | L710 | 13,602 | *,999982 |
| | | | | | | |

L710 ist Luft bei 950mbar.

Asphäre L 103:
EX=0
$C1= -0.10457918*10^{-6}$
$C2= 0,37706931*10^{-11}$
$C3= 0,61848526*10^{-16}$
$C4= -0,13820933*10^{-19}$
$C5= 0,36532387*10^{-24}$
$C6= -0,11262277*10^{-28}$

Asphäre L107:
$EX= 0,4532178*10^2$
$C1= 0,19386780*10^{-7}$
$C2= - 0,22407622*10^{-11}$
$C3= - 0,42016344*10^{-15}$
$C4= 0,45154959*10^{-19}$
$C5= - 0,19814724*10^{-23}$
$C6= - 0,43279363*10^{-28}$

AsphäreL111:
EX=0
$C1= 0.57428624*10^{-8}$
$C2= 0,22697489*10^{-12}$
$C3= - 0,71160755*10^{-18}$
$C4= - 0,72410634*10^{-21}$
$C5= 0,32264998*10^{-25}$,
$C6=-0,55715555*10^{-30}$

Die asphärischen Flächen werden durch die Gleichung:

$$P(h) = \frac{\delta \bullet h \bullet h}{1 + \sqrt{1 - (1 - EX) \bullet \delta \bullet \delta \bullet h \bullet h}} + C_1 h^4 + \ldots + C_n h^{2n+2} \qquad \delta = 1/R$$

beschrieben, wobei P die Pfeilhöhe als Funktion des Radius h (Höhe zur optischen Achse 7) mit den in den Tabellen angegebenen asphärischen Konstanten $C_1$ bis $C_n$ ist. R ist der in den Tabellen angegebene Scheitelradius.

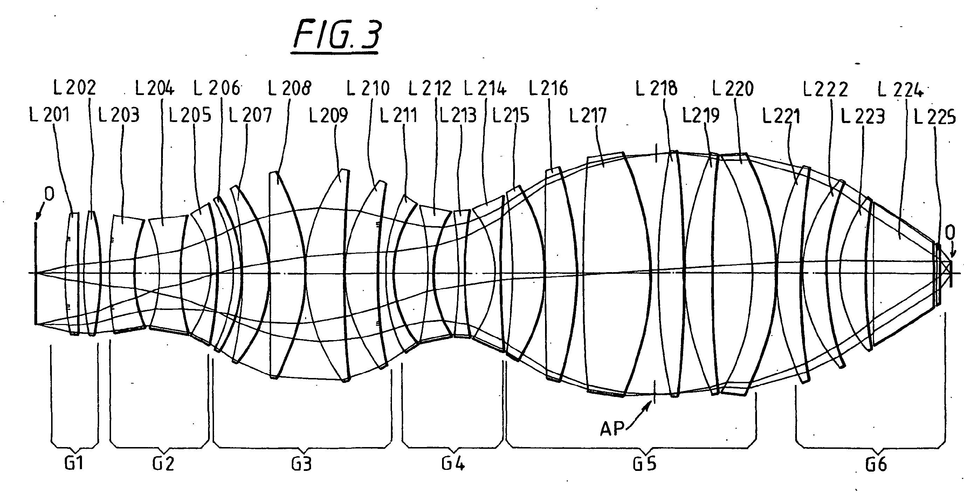

In Figur 3 ist ein Projektionsobjektiv für die Wellenlänge 193 nm gezeigt, das eine numerische Apertur von 0,8 aufweist. Mittels diesem Objektiv ist ein Feld von 8 x 26 belichtbar, wobei der erforderliche Bauraum für dieses Objektiv 1000 mm beträgt.

Die ersten Linsengruppe weist nur zwei Positivlinsen auf, die beide bikonvex sind. Die erste Linse L201 dieser Linsengruppe G1 ist objektseitig mit einer asphärischen Linsenoberfläche versehen.

Die zweite Linsengruppe G2 umfaßt die Linsen L203 - L205, wobei die Linse L203 objektseitig mit einer asphärischen Linsenoberfläche versehen ist. Durch diese beiden in der ersten und zweiten Linsengruppe G1, G2 vorgesehenen asphärischen Linsenoberflächen der Linsen L201 und L203, die feldnah angeordnet sind, wird eine gute Büscheltrennung im Eingangsbereich des Objektives erreicht. Die Anordnung der asphärischen Linsenoberflächen auf der dem Objekt zugewandten Seite hat den Vorteil, daß die eine asphärische Linsenoberfläche aufweisenden Linsen mit der sphärischen Linsenoberfläche auf einer Linsenfassung aufliegen. Damit kann ein gutes Anliegen auf der Linsenfassung mit der sphärischen Linsenoberfläche wesentlich leichter gewährleistet werden.

Die dritte Linsengruppe G3 umfaßt die Linsen L206 - L210. Diese Linsengruppe weist positive Brechkraft auf, wobei die beiden Linsen L208 und L209 zwei zueinander stark gekrümmte Oberflächen aufweisen. Die letzte Linse L210 dieser Linsengruppe weist bildseitig eine asphärische Linsenoberfläche auf. Mittels dieser asphärischen Linsenoberfläche ist eine gute Komakorrektur durchführbar. Weiterhin ist eine Korrektur der axialen und schiefen sphärischen Aberration aufgrund der großen Büscheldurchmesser in diesem Bereich besonders gezielt möglich.

Die vierte Linsengrüppe weist die L211 - L214 auf. Diese Linsengruppe weist insgesamt negative Brechkraft auf. In der darauffolgenden fünften Linsengruppe G5, die die Linsen L215 - L220 umfaßt, ist die Blende nach der Linse L217 angeordnet. Diese Linsengruppe weist drei Positivlinsen auf, wobei die letzte Linse vor der Blende besonders dick ausgestaltet ist. Die letzte Linsengruppe G6 umfaßt die Linsen L221 - L225; wobei die Linse L224 besonders dick ausgestaltet ist. Durch diese Linse wird eine starke sphärische Überkorrektur erreicht.

Die genauen Linsendaten sind der Tabelle 2 zu entnehmen.

**Tabelle 2**

| Linse | Radius | | Dicke | Material | ½ Linsendurchmesser | Brechzahl bei 193nm |
|---|---|---|---|---|---|---|
| | | | | | | |
| 0 | Unendl. | | 32,7500 | L710 | 61,249 | 0,999982 |
| L201 | 469,70813 | A | 14,5480 | SIO2 | 62,591 | 1,560289 |
| | -20081,10295 | | 5,1612 | HE | 63,071 | 0,999712 |
| L202 | 354,86345 | | 18,8041 | SIO2 | 63,983 | 1,560289 |
| | -334,15750 | | 9,4004 | HE | 63,889 | 0,999712 |
| L203 | 381,44025 | A | 28,0599 | SIO2 | 61,107 | 1,560289 |
| | 140,16853 | | 27,1615 | HE | 55,898 | 0,999712 |
| L204 | -149,89590 | | 23,2652 | SIO2 | 55,910 | 1,560289 |
| | 229,41466 | | 33,1065 | HE | 62,024 | 0,999712 |
| L205 | -105,40274 | | 7,0000 | SIO2 | 63,462 | 1,560289 |
| | -336,55620 | | 16,9549 | HE | 74,238 | 0,999712 |
| L206 | -165,03805 | | 10,7419 | SIO2 | 78,416 | 1,560289 |
| | -147,21753 | | 0,7575 | HE | 82,164 | 0,999712 |
| L207 | -314,39712 | | 27,7710 | SIO2 | 90,707 | 1,560289 |
| | -145,41305 | | 0,7500 | HE | 94,176 | 0,999712, |
| L208 | -50326,68803 | | 38,7705 | SIO2 | 107,592 | 1,560289 |
| | -211,33124 | | 0,7500 | HE | 109,537 | 0,999712 |
| L209 | 184,32395 | | 41,8364 | SIO2 | 112,438 | 1,560289 |
| | 1282,45923 | | 0,7500 | HE | 110,470 | 0,999712 |

Tabelle fortgesetzt

| Linse | Radius | | Dicke | Material | ½ Linsendurchmesser | Brechzahl bei 193nm |
|---|---|---|---|---|---|---|
| L210 | 153,97703 | | 35,8150 | SIO2 | 99,821 | 1,560289 |
| | 538,04124 | A | 8,4636 | HE | 95,507 | 0,999712 |
| L211 | 180,72102 | | 7,8641 | SIO2 | 82,558 | 1,560289 |
| | 116,94830 | | 38,5761 | HE | 73,768 | 0,999712 |
| L212 | -292,06054 | | 7,0000 | SIO2 | 71,989 | 1,560289 |
| | 121,89815 | | 26,8278 | HE | 65,096 | 0,999712 |
| L213 | -416, 86096 | | 7,0000 | SIO2 | 65,191 | 1,560289 |
| | 320,06306 | | 34,0097 | HE | 66,681 | 0,999712 |
| L214 | -106,74033 | | 7,1599 | SIO2 | 67,439 | 1,560289 |
| | 842,66128 | | 12,4130 | HE | 82,767 | 0,999712 |
| L215 | -531,44217 | | 35,2270 | SIO2 | 84,311 | 1,560289 |
| | -173,85357 | | 0,7500 | HE | 93,111 | 0,999712 |
| L216 | 5293,05144 | | 34,6817 | SIO2 | 109,462 | 1,560289 |
| | -359,30358 | | 5,8421 | HE | 114,271 | 0,999712 |
| L217 | 1423,10335 | | 73,8658 | SIO2 | 123,709 | 1,560289 |
| | -302,64507 | | 11,7059 | HE | 130,054 | 0,999712 |
| | unendlich | | -4,1059 | HE | 129,751 | 0,999712 |
| | unendlich | | 0,0000 | | 129,751 | |
| L218 | 644,68375 | | 29,3314 | SIO2 | 130,947 | 1,560289 |
| | -1224,04524 | | 0,7500 | HE | 130,998 | 0,999712 |
| L219 | 324,02485 | | 28,7950 | SIO2 | 129,211 | 1,560289 |
| | 1275,35626 | | 44,6599 | HE | 127,668 | 0,999712 |
| L220 | -246,29714 | | 25,7695 | SIO2 | 126,964 | 1,560289 |
| | -260,21284 | | 0,7500 | HE | 129,065 | 0,999712 |
| L221 | 265,62632 | | 25,9894 | SIO2 | 115,965 | 1,560289 |
| | 689,74229 | | 1,8638 | HE | 113,297 | 0,999712 |
| L222 | 148,08236 | | 25,7315 | SIO2 | 100,768 | 1,560289 |
| | 256,32650 | | 14,8743 | HE | 97,685 | 0,999712 |
| L223 | 130,15491 | | 28,8792 | SIO2 | 81,739 | 1,560289 |
| | 554,81058 | | 6,6463 | HE | 77,855 | 0,999712 |
| L224 | unendlich | | 67,6214 | CAF2HL | 76,291 | 1,501436 |
| | unendlich | | 0,9000 | HE | 33,437 | 0,999712 |
| L225 | unendlich | | 4,0000 | SIO2 | 32,220 | 1,560289 |
| 0' | unendlich | | | L710 | 29,816 | 0,999982 |
| | | | | | | |
| | | | | | | |

L710 ist Luft bei 950mbar.

Asphäre L201:

EX=0

C1= 0,98184588 $*10^{-7}$

C2= - 0,34154428 $*10^{-11}$

C3= 0,15764865 $*10^{-15}$

C4= 0,22232520 $*10^{-19}$

C5= - 0,79813714 $*10^{-23}$,

C6= 0,71685766 $*10^{-27}$

Asphäre L203:

EX=0

C1= 0.26561042 $*10^{-7}$

C2= 0,78262804 $*10^{-12}$

C3= - 0,24383904 $*10^{-15}$

C4= - 0,24860738 $*10^{-19}$

C5= 0,82092885 8 $*10^{-23}$

C6= -0,85904366 $*10^{-27}$

Asphäre L210:

EX=0

C1=0.20181058 $*10^{-7}$

C2=-0,73832637$*10^{-12}$

C3= 0,32441071 $*10^{-17}$

C4= - 0,10806428 $*10^{-21}$

C5= - 0,48624119 $*10^{-25}$,

C6= 0,10718490 $*10^{-2}$

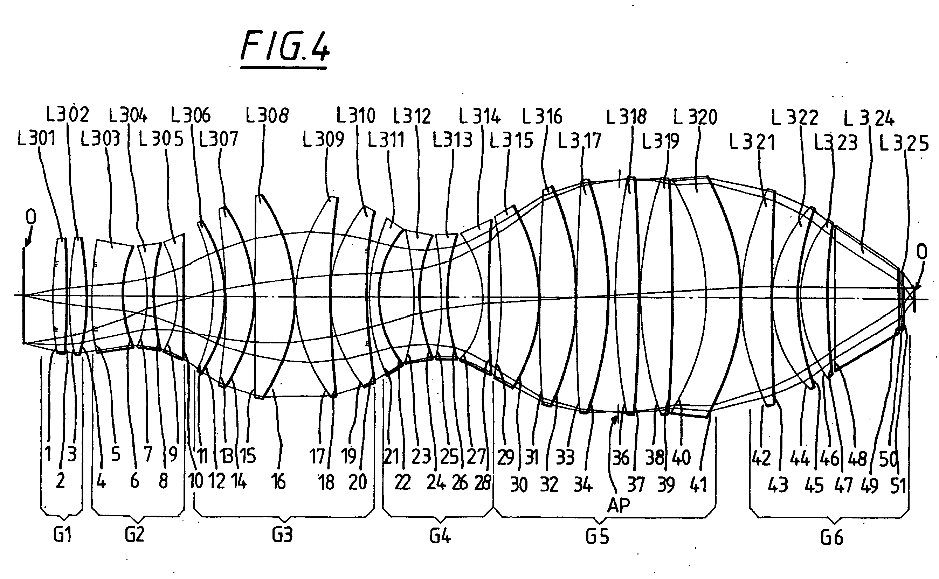

In Figur 4 ist eine weitere für die Wellenlänge 248 nm ausgelegte Linsenanordnung 19 gezeigt. Diese Linsenanordnung umfaßt 25 Linsen, die in 6 Linsengruppen einteilbar sind. Die Baulänge dieser Linsenanordnung von Objektebene 0 bis Bildebene 0' beträgt 1000 mm. Die numerische Apertur dieser Linsenanordnung beträgt bildseitig 0,8.

Die erste Linsengruppe G1 weist zwei positive, bikonvexe Linsen L301 und L302 auf. Die Linse L301 ist objektseitig mit einer asphärischen Linsenoberfläche versehen.

Die zweite Linsengruppe G2, die negative Brechkraft aufweist, umfaßt die Linsen L303 - L305. Die Linse L303 ist objektseitig mit einer asphärischen Linsenoberfläche versehen. Durch diese beiden asphärischen Linsenoberflächen der Linsen L301 und L303 ist eine gute Korrektur von Feldaberrationen möglich. Weiterhin wird durch diese feldnah angeordneten Asphären eine starke Büscheltrennung erreicht..

Die dritte Linsengruppe G3 umfaßt die Linsen L306 - L310 und weist positive Brechkraft auf Die Linse L310 ist bildseitig mit einer asphärischen Linsenoberfläche versehen. Mittels dieser asphärischen Linsenoberfläche ist insbesondere eine gute Korrektur von Koma und der axialen und schiefen sphärischen Aberration möglich. Eine vermittelnde Korrektur zwischen axialen und schiefen sphärischen Aberration ist insbesondere aufgrund großer Büscheldurchmesser, die aber immer noch nennenswert unter den freien Linsendurchmessern liegen, besonders gut möglich.

Die vierte Linsengruppe G4 besteht aus den Linsen L311 - L314 und weist negative Brechkraft auf.

Die fünfte Linsengruppe G5 umfaßt die Linsen L315 - L320 und weist insgesamt positive Brechkraft auf. Nach der Linse L317 ist eine Blende AP angeordnet. Durch Vorsehen des freien Luftraumes zwischen L317 und L318 ist es möglich, eine Schiebeblende zwischen diesen beiden Linsen anzuordnen.

Die sechste Linsengruppe G6 umfaßt die Linsen L321 - L325. Diese Linsengruppe weist ebenfalls positive Brechkraft auf. Die Meniskenlinsen L321- L323 sind zum Objekt durchgebogen. Diese Linsengruppe weist nur noch sammelnde Linsen auf, die eine feldunabhängig, starke sphärische Überkorrektur bewirken. Bei Objektiven mit einer hohen Apertur ist mittels solcher Sammellinsen auch eine Korrektur der sphärischen Aberration auch höherer Ordnung möglich.

Dieses Objektiv ist insbesondere durch den Einsatz der asphärischen Linsenoberflächen, sowie durch die spezielle Anordnung der Anzahl der Positivlinsen der ersten Linsengruppe und der höheren Anzahl an Positivlinsen vor der Blende besonders gut korrigiert. Die Abweichung von der Wellenfront einer idealen Kugelwelle beträgt max. 5,0 mλ bei einer Wellenlänge von 248 nm.

Vorzugsweise sind die asphärischen Linsenoberflächen auf der vorderen erhabenen Linsenfläche angeordnet, wodurch die entsprechende Linse mit ihrer sphärischen Linsenoberfläche auf der Fassungsfläche aufliegt. Damit können diese asphärischen Linsen mittels Standardfassungen gefaßt werden.

Die genauen Linsendaten sind Tabelle 3 zu entnehmen.

**TABELLE 3** M1652a

| FLAECHE | RADIEN | DICKEN | GLAESER | BRECHZAHL 248.338nm | 1/2 FREIER DURCHMESSER |
|---|---|---|---|---|---|
| 0 | unendlich | 32.750000000 | L710 | 09999820 | 54.410 |

Tabelle fortgesetzt

| FLAECHE | RADIEN | DICKEN | GLAESER | BRECHZAHL 248.338nm | 1/2 FREIER DURCHMESSER |
|---|---|---|---|---|---|
| 1 | 480.223886444AS | 16.335451604 | SIO2 | 1.50839641 | 62.519 |
| 2 | -1314.056977504 | 2.406701682 | L710 | 0.99998200 | 63.128 |
| 3 | 329.047567482 | 20.084334424 | SIO2 | 1.5083964 | 63.870 |
| 4 | -305.091682732 | 4.971873027 | L710 | 0.99998200 | 63.737 |
| 5 | 383.800850809AS | 34.498893572 | SIO2 | 1.50839641 | 61.345 |
| 6 | 132.468446407 | 27.572735356 | L710 | 0.99998200 | 54.949 |
| 7 | -146.238861297 | 7.000000000 | SIO2 | 1.5083964 | 54.908 |
| 8 | 202.067070373 | 26.902804948 | L710 | 0.99998200 | 58.294 |
| 9 | -124.604159239 | 7.000000000 | SIO2 | 1.5083964 | 59.529 |
| 10 | -9484.579900199 | 32.328722869 | L710 | 0.99998200 | 69.147 |
| 11 | -199.920035154 | 13.239699068 | SIO2 | 1.5083964 | 80.852 |
| 12 | -156.061108055 | 0.750000376 | L710 | 0.99998200 | 84.387 |
| 13 | -647.599685325 | 32.765465982 | SIO2 | 1.5083964 | 96.077 |
| 14 | -169.327287667 | 0.750000000 | L710 | 0.99998200 | 99.492 |
| 15 | 54987.154632328 | 43.791248851 | SIO2 | 1.5083964 | 110.237 |
| 16 | -198.179168899 | 0.750000000 | L710 | 0.99998200 | 112.094 |
| 17 | 179.965671297 | 37.961498762 | SIO2 | 1.5083964 | 110.618 |
| 18 | 730.008903751 | 0.750000000 | L710 | 0.99998200. | 108.526 |
| 19 | 155.802150060 | 40.190627192 | SIO2 | 1.5083964 | 99.471 |
| 20 | 525.570694901AS | 3.398727679 | L710 | 0.99998200 | 93.056 |
| 21 | 210.625893853 | 10.671567855 | SIO2 | 1.5083964 | 85.361 |
| 22 | 118.365024068 | 39.388505884 | L710 | 0.99998200 | 74.596 |
| 23 | -290.993996128 | 7.000000000 | SIO2 | 1.5083964 | 72.941 |
| 24 | 153.643732808 | 24.440280468 | L710 | 0.99998200 | 67.256 |
| 25 | -364.763623225 | 7.000000000 | SIO2 | 1.5083964 | 67.177 |
| 26 | 201.419421908 | 40.566258495 | L710 | 0.99998200 | 68.276 |
| 27 | -109.336657265 | 7.000000000 | SI02 | 1.5083964 | 69.319 |
| 28 | 1061.293067334 | 13.765515688 | L710 | 0.99998200 | 84.656 |
| 29 | -569.739152405 | 43.187833722 | SIO2 | 1.5083964 | 87.749 |
| 30 | -187.461049756 | 0.750000000 | L710 | 0.99998200 | 99.718 |
| 31 | 1880.153525684 | 40.009394091 | SIO2 | 1.5083964 | 117.515 |
| 32 | -286.975850149 | 0.750000000 | L710 | 0.99998200 | 120.535 |
| 33 | 1960.535354230 - | 35.788625356 | SIO2 | 1.50839641 | 127.909 |
| 34 | -378.322213808 | 11.705900000 | L710 | 0.99998200 | 129.065 |
| 35 | unendlich | -4.105900000 | L710 | 0.99998200 | 129.546 |
| 36 | 665.988216308 | 27.299895961 | SIO2 | 1.5083964 | 130.708 |
| 37 | -1514.956732781 | 0.750000000 | L710 | 0.99998200 | 130.863 |
| 38 | 392.166724592 | 35.529695156 | SIO2 | 1.5083964 | 130.369 |
| 39 | -2215.367253951 | 37.377386813 | L710 | 0.99998200 | 129.155 |
| 40 | -235.632993037 | 38.989537996 | SIO2 | 1.5083964 | 128.458 |
| 41 | -252.020337993 | 0.835229633 | L710 | 0.99998200 | 131.819 |
| 42 | 269.631401556 | 32.688617719 | SIO2 | 1.5083964 | 118.998 |
| 43 | 1450.501345093 | 0.750000001 | L710 | 0.99998200 | 116.187 |
| 44 | 138.077824305 | 29.652384517 | SIO2 | 1.5083964 | 100.161 |
| 45 | 255.416969175 | 2.589243681 | L710 | 0.99998200 | 96.793 |
| 46 | 139.090220366 | 30.752909421 | SIO2 | 1.5083964 | 86.930 |
| 47 | 560.532964454 | 8.142484947 | L710 | 0.99998200 | 82.293 |
| 48 | unendlich | 73.619847203 | SIO2 | 1.5083964 | 79.524 |
| 49 | unendlich | 0.900000000 | L710 | 0.99998200 | 33.378 |

Tabelle fortgesetzt

| FLAECHE | RADIEN | DICKEN | GLAESER | BRECHZAHL 248.338nm | 1/2 FREIER DURCHMESSER |
|---|---|---|---|---|---|
| 50 | unendlich | 4.000000000 | SIO2 | 1509641 | 32.173 |
| 51 | unendlich | 12.000000000 | L710 | 0999820 | 29.666 |
| 52 | unendlich | | | | 13.603 |

L710 ist Luft bei 950 mbar

```
ASPHAERISCHE KONSTANTEN
```

| FLAECHE NR.   1 | | | |
|---|---|---|---|
| EX | 0.0000 | C1 | 9.53339646e-008 |
| C2 | -3.34404782e-012 | C3 | 1.96004118e-016 |
| C4 | 8.21742864e-021 | C5 | -5.28631864e-024 |
| C6 | 4.96925973e-028 | C7 | 0.00000000e+000 |
| C8 | 0.00000000e+000 | C9 | 0.00000000e+000 |
| FLAECHE NR.   5 | | | |
| EX | 0.0000 | | |
| C1 | 2.89631842e-008 | C2 | 7.74237590e-013 |
| C3 | -2.72916513e-016 | C4 | -8.20523716e-021 |
| C5 | 4.42916563e-024 | C6 | -5.10235191e-028 |
| C7 | 0.00000000e+000 | C8 | 0.00000000e+000 |
| C9 | 0.00000000e+000 | | |
| FLAECHE NR.   20 | | | |

```
Ex        0.0000
C1     1.99502967e-008
C2    -7.64732709e-013
C3     3.50640997e-018
C4    -2.76255251e-022
C5    -3.64439666e-026
C6     5.10177997e-031
C7     0.00000000e+000
```

**Patentansprüche**

1. Projektionsobjektiv, umfassend eine erste Linsengruppe (G1) positiver Brechkraft, eine zweite Linsengruppe (G2) negativer Brechkraft und mindestens eine weitere Linsengruppe positiver Brechkraft, in der eine Blende angeordnet ist, und wobei die erste Linsengruppe (G1) ausschließlich aus Linsen positiver Brechkraft besteht, **dadurch gekennzeichnet, dass** die Anzahl der Linsen positiver Brechkraft (L101-L103; L201-L202) der ersten Linsengruppe (G1) kleiner ist als die Anzahl der Linsen positiver Brechkraft (L116-L119; L215-L217), die vor der Blende in der weiteren Linsengruppe (G5) unmittelbar aufeinander folgend angeordnet sind.

2. Projektionsobjektiv nach Anspruch 1, **dadurch gekennzeichnet, dass** mindestens eine Linse der ersten Linsengruppe (G1) eine asphärische Linse (L103,L201) ist.

3. Projektionsobjektiv nach Anspruch 1, **dadurch gekennzeichnet, dass** die erste Linsengruppe(G1) mindestens zwei Positivlinsen (L201 - L202, L101 - L103) aufweist.

4. Projektionsobjektiv nach Anspruch 1, **dadurch gekennzeichnet, dass** alle Linsen (L201 - L202, L101 - L103) der ersten Linsengruppe (G1) bikonvex sind.

5. Projektionsobjektiv nach Anspruch 2, **dadurch gekennzeichnet, dass** die Asphärizität der asphärischen Linse (L103) in der ersten Linsengruppe (G1) um mehr als 200 µm gegenüber der am besten passenden sphärischen Linsenoberfläche abweicht.

6. Projektionsobjektiv nach mindestens einem der vorangegangenen Ansprüche, **dadurch gekennzeichnet, daß** das Objektiv eine numerische Apertur von mindestens 0,8, vorzugsweise 0,9, aufweist.

7. Projektionsobjektiv nach mindestens einem der vorangegangenen Ansprüche, **dadurch gekennzeichnet, daß** die Linsen bzw. der 1. und 2. Linsengruppe, abgesehen von der letzten Linse der zweiten Linsengruppe (G2), nahezu identischen Durchmesser aufweisen.

8. Projektionsobjektiv nach mindestens einem der vorangegangenen Ansprüche, **dadurch gekennzeichnet, daß** die Durchmesser mindestens der ersten neun Linsenoberflächen nahezu gleich groß sind und vorzugsweise weniger als das 1,3 fache des Objektfeldes betragen.

9. Projektionsobjektiv nach einem der Ansprüche 7 oder 8, **dadurch gekennzeichnet, daß** der annähernd gleiche Durchmesser (D1) der objektseitig angeordneten Linsen in etwa halb so groß ist wie der maximale Durchmesser (D2) der nachfolgenden Linse (L 120, L218).

10. Projektionsobjektiv nach mindestens einem der vorangegangenen Ansprüche , **dadurch gekennzeichnet, daß** das Projektionsobjektiv Bestandteil einer Projektionsbelichtungsanlage der Mikrolithographie ist, die vorzugsweise einen Excimerlaser als Lichtquelle zur Bereitstellung der für die Projektionsbelichtung benötigten Strahlung, die von kürzere Wellenlänge als 250nm ist, aufweist.

11. Verfahren zur Herstellung mikrostrukturierter Bauteile, bei dem ein mit einer lichtempfindlichen Schicht versehenes Substrat mittels einer Maske und einer Projektionsbelichtungsanlage mit einem Projektionsobjektiv nach mindestens einem der vorangegangenen Ansprüche 1-10 durch ultraviolettes Laserlicht belichtet wird und gegebenenfalls nach Entwicklung der lichtempfindlichen Schicht entsprechend einem auf der Maske enthaltenen Muster strukturiert wird.

## Revendications

1. Objectif de projection comprenant un premier groupe de lentilles (G1) à réfringence positive, un deuxième groupe de lentilles (G2) à réfringence négative et au moins un groupe de lentilles supplémentaire à réfringence positive dans lequel est disposé un diaphragme, et le premier groupe de lentilles (G1) se composant exclusivement de lentilles à réfringence positive, **caractérisé en ce que** le nombre de lentilles à réfringence positive (L101-L103 ; L201-L202) du premier groupe de lentilles (G1) est inférieur au nombre de lentilles à réfringence positive (L116-L119 ; L215-L217) qui sont disposées directement les unes à la suite des autres devant le diaphragme dans le groupe de lentilles supplémentaire (G5).

2. Objectif de projection selon la revendication 1, **caractérisé en ce qu'**au moins une lentille du premier groupe de lentilles (G1) est une lentille asphérique (L103, L201).

3. Objectif de projection selon la revendication 1, **caractérisé en ce que** le premier groupe de lentilles (G1) présente au moins deux lentilles positives (L201-L202, L101-L103).

4. Objectif de projection selon la revendication 1, **caractérisé en ce que** toutes les lentilles (L201-L202, L101-L103) du premier groupe de lentilles (G1) sont biconvexes.

5. Objectif de projection selon la revendication 2, **caractérisé en ce que** le caractère asphérique de la lentille asphérique (L103) dans le premier groupe de lentilles (G1) diffère de plus de 200 $\mu$m de la surface de la lentille sphérique la mieux adaptée.

6. Objectif de projection selon au moins l'une des revendications précédentes, **caractérisé en ce que** l'objectif présente une ouverture numérique d'au moins 0,8, de préférence de 0,9.

7. Objectif de projection selon au moins l'une des revendications précédentes, **caractérisé en ce que** les lentilles ou le 1$^{er}$ et le 2$^{ème}$ groupe de lentilles, à l'exception de la dernière lentille du deuxième groupe de lentilles (G2), présentent des diamètres quasiment identiques.

8. Objectif de projection selon au moins l'une des revendications précédentes, **caractérisé en ce que** les diamètres d'au moins les neuf premières surfaces de lentille sont quasiment identiques et sont de préférence inférieurs à 1,3 fois le champ de l'objectif.

9. Objectif de projection selon l'une des revendications 7 ou 8, **caractérisé en ce que** le diamètre (D1) quasiment identique des lentilles disposées du côté de l'objet est approximativement égal à la moitié du diamètre maximum (D2) de la lentille suivante (L120, L218).

10. Objectif de projection selon au moins l'une des revendications précédentes, **caractérisé en ce que** l'objectif de projection est un composant d'un équipement d'éclairage de projection de microlithographie qui présente de préférence un laser excimer comme source de lumière pour la fourniture du rayonnement nécessaire à l'éclairage de projection, lequel a une longueur d'onde plus courte que 250 nm.

11. Procédé de fabrication de composants microstructurés avec lequel un substrat muni d'une couche photosensible est éclairé par de la lumière laser ultraviolette au moyen d'un masque et d'un équipement d'éclairage de projection muni d'un objectif de projection selon au moins l'une des revendications 1 à 10 et, le cas échéant après développement de la couche photosensible, est structuré conformément à un modèle présent sur le masque.

**Claims**

1. Projection objective comprising a first lens group (G1) of positive power, a second lens group (G2) of negative power and at least one further lens group of positive power in which a diaphragm is arranged, and the first lens group (G1) comprising lenses of positive power only, **characterized in that** the number of the lenses of positive power (L101-L103; L201-L202) of the first lens group (G1) is smaller than the number of the lenses of positive power (L116-L119; L215-L217) which are arranged immediately following one another upstream of the diaphragm in the further lens group (G5).

2. Projection objective according to Claim 1, **characterized in that** at least one lens of the first lens group (G1) is an aspheric lens (L103, L201).

3. Projection objective according to Claim 1, **characterized in that** the first lens group (G1) has at least two positive lenses (L201-L202, L101-L103).

4. Projection objective according to Claim 1, **characterized in that** all the lenses (L201-L202, L101-L103) of the first lens group (G1) are biconvex.

5. Projection objective according to Claim 2, **characterized in that** the asphericity of the aspheric lens (L103) in the first lens group (G1) deviates by more than 200 $\mu$m from the most suitable spherical lens surface.

6. Projection objective according to at least one of the preceding claims, **characterized in that** the objective has a numerical aperture of at least 0.8, preferably 0.9.

7. Projection objective according to at least one of the preceding claims, **characterized in that**, apart from the last lens of the second lens group (G2), the lenses of the first and second lens group, respectively, have virtually identical diameters.

8. Projection objective according to at least one of the preceding claims, **characterized in that** the diameters of at least the first nine lens surfaces are of virtually the same size and are preferably less than 1.3 times the object field.

9. Projection objective according to either of Claims 7 and 8, **characterized in that** the approximately identical diameter (D1) of the lens arranged on the object side is approximately half as large as the maximum diameter (D2) of the downstream lens (L120, L218).

10. Projection objective according to at least one of the preceding claims, **characterized in that** the projection objective is a component of a microlithography projection exposure machine which preferably has an excimer laser as light source for providing the radiation required for the projection exposure, which is of wavelength shorter than 250 nm.

11. Method for producing microstructured components, in the case of which a substrate provided with a photosensitive layer is exposed to ultraviolet laser light by means of a mask and a projection exposure machine having a projection objective according to at least one of the preceding Claims 1-10, and, if appropriate after development of the photosensitive layer, patterned in accordance with a pattern contained on the mask.

# FIG. 1

FIG.2

## FIG.3

L 201  L 202  L 203  L 204  L 205  L 206  L 207  L 208  L 209  L 210  L 211  L 212  L 213  L 214  L 215  L 216  L 217  L 218  L 219  L 220  L 221  L 222  L 223  L 224  L 225

O

AP

G1    G2    G3    G4    G5    G6

EP 1 217 412 B1

FIG.4

EP 1 217 412 B1